# FASCICULE DE BREVET EUROPEEN

(11) **EP 2 239 842 B1**
(45) Date de publication et mention de la délivrance du brevet: **26.10.2011**
(21) Numéro de dépôt: 09157505.0
(22) Date de dépôt: 07.04.2009
(51) Int. Cl.: H03F 3/45, H03K 5/08

(54) **Circuit amplificateur à faible bruit de phase**
Verstärkerschaltkreis mit schwachem Phasengeräusch
Amplifier circuit with reduced phase noise

(43) Date de publication de la demande: 13.10.2010
(73) Titulaire: The Swatch Group Research and Development Ltd., 2074 Marin (CH)
(72) Inventeur: Velasquez, Carlos, 2000 Neuchâtel (CH)
(74) Mandataire: Surmely, Gérard

(56) Documents cités:
- CH-A5- 689 088
- US-A1- 2004 251 882
- US-A1- 2004 257 119
- US-A1- 2007 252 621
- US-B1- 7 068 077

## Description

L'invention concerne un circuit amplificateur à faible bruit de phase, notamment pour la fourniture d'au moins un signal d'horloge ou de base de temps. Ce circuit amplificateur, qui peut être un circuit amplificateur opérationnel à transconductance, comprend une paire différentielle de transistors MOS ou bipolaires en entrée, des premier et second miroirs de courant reliés aux transistors de la paire différentielle, et un troisième miroir de courant relié aux premier et second miroirs de courant entre deux bornes d'une source de tension d'alimentation. Un noeud de connexion entre les premier et troisième miroirs de courant fournit un signal de sortie, dont le niveau peut s'étendre sur toute la plage de tension d'alimentation.

Le circuit amplificateur de la présente invention peut être considéré comme un circuit tampon. Un tel circuit tampon est un circuit intermédiaire d'amplification disposé par exemple entre un oscillateur à quartz délivrant un ou deux signaux oscillants en opposition de phase, et une unité de conversion de fréquence ou de traitement de données. Ce circuit intermédiaire permet de convertir des signaux oscillants, qui peuvent être de forme sinusoïdale, à faible amplitude, en au moins un signal de sortie à impulsions. Le signal de sortie à impulsions s'étend sur toute la plage de tension d'alimentation, ce qui est défini par le terme anglais "rail-to-rail". L'unité de conversion de fréquence peut comprendre un synthétiseur de fréquence ou faire partie d'un récepteur ou émetteur de signaux radiofréquences, tels que GPS ou Bluetooth, et l'unité de traitement de données peut être en partie un convertisseur analogique-numérique ou un convertisseur DC-DC.

Lorsqu'un tel circuit amplificateur est utilisé en liaison avec un oscillateur à quartz pour fournir au moins un signal d'horloge ou de base de temps dans un instrument électronique, il survient généralement une détérioration du bruit de phase ou une dégradation de la gigue importante. Ceci peut nuire au bon fonctionnement de l'instrument électronique, et peut nécessiter l'emploi de circuits fort consommateur d'énergie électrique pour éviter la dégradation du bruit de phase.

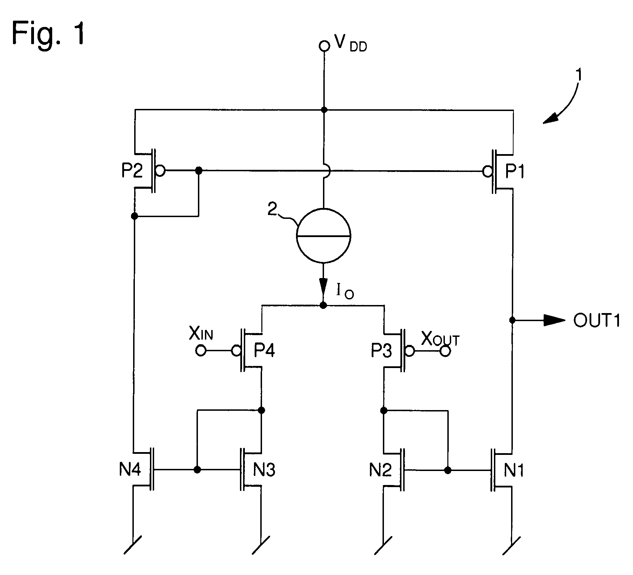

Une structure connue d'un circuit amplificateur opérationnel à transconductance est représentée à la figure 1. Ce circuit amplificateur 1 est susceptible de fournir un signal de sortie OUT1, qui peut s'étendre sur toute la plage de tension d'alimentation ("rail-to-rail" en terminologie anglaise). Un tel circuit amplificateur opérationnel à transconductance de structure inverse est également décrit dans le brevet CH 689 088 (figure 5) pour une utilisation comme moyen de polarisation active dans un oscillateur à quartz.

Le circuit amplificateur de cette figure 1, comprend une paire différentielle de transistors PMOS P3 et P4, dont les sources des deux transistors PMOS sont reliées ensemble à une source de courant 2. Cette source de courant 2, qui est reliée à une borne de potentiel haut V_{DD} de la source de tension d'alimentation, fournit un courant constant I₀ à la paire différentielle de transistors PMOS. La grille du premier transistor d'entrée PMOS P3 constitue une entrée non inverseuse X_{OUT}, alors que la grille du second transistor d'entrée PMOS P4 constitue une entrée inverseuse X_{IN} du circuit amplificateur 1.

Le drain du premier transistor d'entrée PMOS P3 est relié à un transistor NMOS monté en diode N2 d'un premier miroir de courant relié à une borne de potentiel bas de la source de tension d'alimentation, par exemple à la masse. La grille du transistor monté en diode NMOS N2 est connectée à la grille d'un second transistor identique NMOS N1 du premier miroir de courant pour permettre de miroiter le courant traversant le transistor NMOS N2 dans le second transistor NMOS N1. Le drain du second transistor d'entrée PMOS P4 est relié à un transistor NMOS monté en diode N3 d'un second miroir de courant relié à une borne de potentiel bas de la source de tension d'alimentation, par exemple à la masse. La grille du transistor monté en diode NMOS N3 est connectée à la grille d'un second transistor identique NMOS N4 du second miroir de courant pour permettre de miroiter le courant traversant le transistor NMOS N3 dans le second transistor NMOS N4.

Le drain du second transistor NMOS N4 du second miroir de courant est relié à un transistor PMOS monté en diode P2 d'un troisième miroir de courant, qui est relié à une borne de potentiel haut V_{DD} de la source de tension d'alimentation. La grille de ce transistor PMOS P2 monté en diode est connectée à la grille d'un second transistor PMOS P1 du troisième miroir de courant pour permettre de miroiter le courant traversant le transistor PMOS monté en diode P2 dans le second transistor identique PMOS P1. Finalement, le drain du second transistor PMOS P1 du troisième miroir de courant est relié au drain du second transistor NMOS N1 du premier miroir de courant afin de définir un noeud de sortie pour fournir un signal de sortie OUT1.

Lorsque la tension appliquée à l'entrée inverseuse X_{IN} du second transistor PMOS P4 de la paire différentielle est inférieure à la tension appliquée à l'entrée non inverseuse X_{OUT} du premier transistor PMOS P3 de la paire différentielle, le courant I₀ de la source de courant 2 passe par les second et troisième miroirs de courant. De ce fait, le niveau du signal de sortie OUT1 est proche de la tension d'alimentation V_{DD}. Inversement lorsque la tension appliquée à l'entrée non inverseuse X_{OUT} du premier transistor PMOS P3 est inférieure à la tension appliquée à l'entrée inverseuse X_{IN} du second transistor PMOS P4, le courant de la source de courant 2 passe par le premier miroir de courant. Dans ces conditions, le niveau du signal de sortie OUT1 est proche de la masse. Toutefois au seuil de conduction de chaque transistor PMOS P3 et P4 de la paire différentielle quand le niveau de tension sur chaque entrée X_{IN} et X_{OUT} est proche, il survient généralement une dégradation importante du bruit de phase. Ce bruit de phase se dégrade en particulier au moment de la transition de conduction entre les deux transistors PMOS de la paire différentielle avec deux signaux oscillants en opposition de phase de forme sinusoïdale appliqués respectivement sur l'entrée inverseuse X_{IN} et l'entrée non inverseuse X_{OUT}.

Le courant dans chaque miroir de courant, qui est relié au transistor PMOS respectif de la paire différentielle, n'est généralement pas coupé rapidement lors de la transition de conduction des transistors PMOS de la paire différentielle. Il subsiste un courant non nul dans le miroir de courant, qui devrait normalement être dans un état non conducteur, ce qui diminue le gain de l'amplificateur et permet au bruit généré dans les transistors ou dans un circuit externe, comme par exemple la source d'alimentation, de faire varier aléatoirement l'instant de transition. Ceci se traduit par une dégradation du bruit de phase du signal. Cela constitue donc un inconvénient d'un tel circuit amplificateur lorsqu'il est utilisé par exemple dans un synthétiseur de fréquence, dans un récepteur de signaux radiofréquences, dans un convertisseur analogique-numérique ou un convertisseur DC-DC.

Dans une forme simplifiée de réalisation d'un circuit amplificateur opérationnel à transconductance (OTA), il peut être fait référence au brevet US 6,806,744. Le circuit amplificateur de ce brevet ne comprend qu'une paire différentielle de transistors PMOS reliée d'une part à une source de courant reliée à une borne de potentiel haut d'une source de tension d'alimentation et d'autre part à un seul miroir de courant du type NMOS relié à la masse. Un noeud de connexion entre un transistor NMOS du miroir et un des transistors PMOS de la paire différentielle fournit le signal de sortie du circuit amplificateur. Cependant avec une telle structure, le signal de sortie ne peut pas s'étendre sur toute la plage de tension d'alimentation, comme pour la présente invention. De plus rien n'est prévu pour éviter une dégradation du bruit de phase, ce qui constitue un autre inconvénient.

L'invention a donc pour but de pallier aux inconvénients de l'état de la technique en fournissant un circuit amplificateur à faible bruit facile à réaliser et permettant d'assurer une conversion de signaux oscillants en entrée en au moins un signal de sortie à impulsions s'étendant sur toute la plage de la tension d'alimentation.

A cet effet, l'invention concerne un circuit amplificateur cité ci-devant, qui se caractérise en ce qu'il comprend un premier transistor complémentaire d'un second type de conductivité monté en parallèle avec le transistor monté en diode du premier miroir de courant et monté sous forme d'inverseur avec le premier transistor de la paire différentielle, la grille ou la base du premier transistor complémentaire étant reliée à la grille ou la base du premier transistor de la paire différentielle, et en ce qu'il comprend un second transistor complémentaire d'un second type de conductivité monté en parallèle avec le transistor monté en diode du second miroir de courant et monté sous forme d'inverseur avec le second transistor de la paire différentielle, la grille ou la base du second transistor complémentaire étant reliée à la grille ou la base du second transistor de la paire différentielle.

Un avantage du circuit amplificateur selon l'invention est qu'il permet de faiblement dégrader le bruit de phase pour convertir des signaux oscillants en entrée du circuit amplificateur en au moins un signal de sortie susceptible de s'étendre sur toute la plage de la tension d'alimentation du circuit amplificateur. Lors de la transition de conduction des transistors de la paire différentielle, notamment du type MOS, la tension des grilles des premier ou second miroirs de courant est diminuée de manière active et plus rapidement grâce aux transistors complémentaires, qui assurent également un gain supplémentaire important. Ceci permet de réduire le temps pendant lequel le bruit de phase peut être généré. De ce fait, le courant dans chaque miroir de courant, qui passe dans un état non conducteur, diminue rapidement.

Les signaux oscillants en opposition de phase, par exemple de forme sinusoïdale, peuvent provenir d'un oscillateur à quartz. Le signal de sortie du circuit amplificateur peut constituer ainsi un signal d'horloge pour cadencer des opérations d'un instrument électronique, tel qu'un synthétiseur de fréquence, un récepteur de signaux radiofréquences GPS ou Bluetooth, un convertisseur analogique-numérique ou un convertisseur DC/DC.

Avantageusement, les transistors peuvent être des transistors du type MOS. Ainsi, les transistors MOS complémentaires forment chacun avec les transistors MOS correspondants de la paire différentielle une paire d'inverseurs pour définir des entrées pseudo-différentielles du circuit amplificateur. Ceci permet également d'avoir un bon rapport cyclique grâce à la symétrie des entrées pseudo-différentielles pour la conversion de signaux oscillants en opposition de phase.

Avantageusement, un quatrième miroir de courant comprend un transistor monté en diode d'un premier type de conductivité, qui est relié directement à la source de courant entre deux bornes d'une source de tension d'alimentation. Ce transistor monté en diode miroite le courant le traversant dans un second transistor du quatrième miroir. Le courant de ce second transistor est fourni aux sources ou émetteurs des transistors de la paire différentielle, ce qui permet d'avoir un bon rapport de réjection de bruit de la tension d'alimentation (PSRR). De préférence, les transistors sont du type MOS.

Avantageusement, la paire différentielle de transistors MOS d'un premier type de conductivité est réalisée avec des transistors PMOS. Les premier et second miroirs de courant sont réalisés avec des transistors du type NMOS d'un second type de conductivité. Les troisième et quatrième miroirs de courant sont réalisés avec des transistors du type PMOS. Finalement les deux transistors complémentaires sont réalisés avec des transistors du type NMOS.

Avantageusement, un inverseur est prévu en sortie du circuit amplificateur pour fournir un signal de sortie inversé. Cet inverseur permet de convertir le noeud de connexion des drains ou collecteurs des seconds transistors des premier et troisième miroirs de courant, qui est à haute impédance, en un signal de sortie en basse impédance.

Avantageusement, les transistors MOS du circuit amplificateur sont configurés pour recevoir des signaux oscillants en opposition de phase en entrée, qui peuvent être à une fréquence supérieure à 10 MHz, par exemple à 16 MHz, et pour fournir un signal amplifié de sortie inversé, qui peut être utilisé comme un signal d'horloge ou de cadencement d'opérations dans un instrument électronique. Le bruit de phase généré et mesuré en décalage de la fréquence des signaux oscillants d'entrée peut être de plus de 10 dB inférieur à celui d'une structure de circuit amplificateur de l'état de la technique.

Les buts, avantages et caractéristiques du circuit amplificateur à faible bruit apparaîtront mieux dans la description suivante sur la base de formes d'exécution non limitatives illustrées par les dessins sur lesquels :
la figure 1 déjà citée représente une forme d'exécution d'un circuit amplificateur selon l'art antérieur,
la figure 2 représente une première forme d'exécution d'un circuit amplificateur selon l'invention, et
la figure 3 représente une seconde forme d'exécution d'un circuit amplificateur selon l'invention.

Dans la description suivante, tous les éléments du circuit amplificateur qui sont bien connus de l'homme du métier dans ce domaine technique ne seront relatés que de manière simplifiée, notamment en ce qui concerne la réalisation de chaque transistor du circuit amplificateur. Le circuit amplificateur de la présente invention est principalement utilisé pour la fourniture d'au moins un signal d'horloge ou de base de temps dans des instruments électroniques, sur la base de signaux oscillants en opposition de phase d'un oscillateur à quartz. Les transistors décrits ci-après sont de préférence des transistors du type MOS, même s'il peut être envisagé également de réaliser le circuit amplificateur avec des transistors bipolaires ou une combinaison de transistors MOS et bipolaires. A ce titre, il est à noter que chaque transistor PMOS décrit ci-après définit un transistor MOS d'un premier type de conductivité, alors que chaque transistor NMOS définit un transistor MOS d'un second type de conductivité, l'inverse pouvant être aussi envisagé.

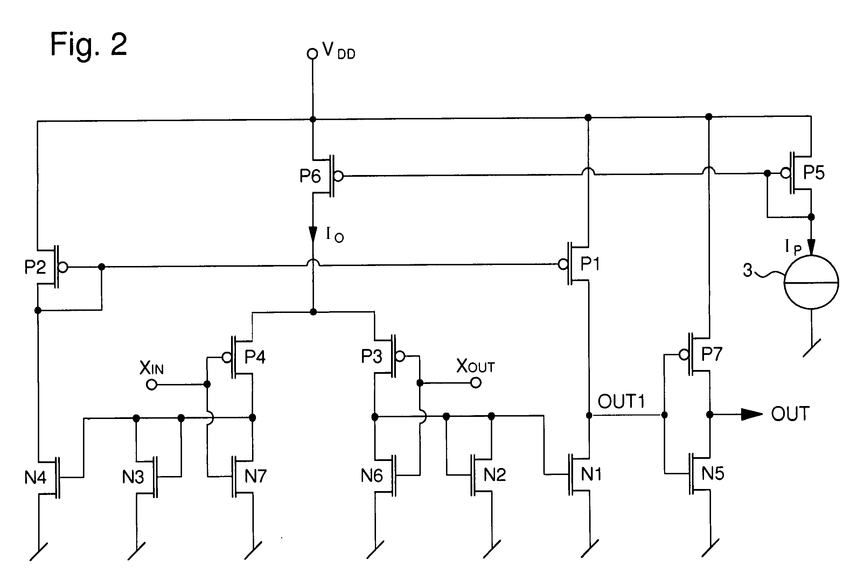

A la figure 2, il est représenté une première forme d'exécution d'un circuit amplificateur à faible bruit 1. Ce circuit est un circuit amplificateur opérationnel à transconductance (OTA). Ce circuit amplificateur de la présente invention se base principalement sur la structure du circuit amplificateur décrit ci-devant et représenté à la figure 1.

Le circuit amplificateur 1 comprend donc tout d'abord une paire différentielle de transistors PMOS P3 et P4. Les sources des transistors PMOS de la paire différentielle sont reliées afin de recevoir un courant constant I₀ généré par l'intermédiaire d'une source de courant 3. La grille d'un premier transistor PMOS P3 de la paire différentielle définit une entrée non inverseuse X_{OUT}, alors que la grille d'un second transistor PMOS P4 de ladite paire définit une entrée inverseuse X_{IN}. Un drain du premier transistor PMOS P3 de la paire différentielle est relié directement à un premier transistor NMOS monté en diode N2 d'un premier miroir de courant. La source du premier transistor NMOS monté en diode N2 est reliée directement à une borne de potentiel bas d'une source de tension d'alimentation V_{DD}, notamment à la masse. Un drain du second transistor PMOS P4 de la paire différentielle est relié directement à un premier transistor NMOS monté en diode N3 d'un second miroir de courant. La source du premier transistor NMOS monté en diode N3 est reliée directement à la masse.

Un premier transistor PMOS monté en diode P2 d'un troisième miroir de courant est relié au drain d'un second transistor NMOS N4 du second miroir de courant, dont la grille est reliée à la grille et au drain du premier transistor monté en diode N3. La source du second transistor NMOS N4 est directement reliée à la masse, alors que la source du premier transistor PMOS monté en diode P2 du troisième miroir de courant est reliée directement à la borne de potentiel haut V_{DD} de la source de tension d'alimentation. Le courant traversant le premier transistor NMOS monté en diode N3 peut ainsi être miroité dans le second transistor NMOS N4 du second miroir de courant afin de traverser le premier transistor PMOS P2 du troisième miroir de courant. Le troisième miroir de courant comprend encore un second transistor PMOS P1, dont la grille est reliée à la grille et au drain du premier transistor PMOS monté en diode P2, et la source est reliée à la borne de potentiel haut V_{DD}. Le courant traversant le premier transistor PMOS monté en diode P2 peut ainsi être miroité dans le second transistor PMOS P1.

Le drain du second transistor PMOS P1 du troisième miroir de courant est relié au drain d'un second transistor NMOS N1 du premier miroir de courant pour définir une première sortie OUT1 du circuit amplificateur. La grille du second transistor NMOS N1 du premier miroir de courant est reliée à la grille et au drain du premier transistor NMOS monté en diode N2, alors que la source du second transistor NMOS N1 est reliée directement à la masse. Ainsi, le troisième miroir de courant est monté en série avec le premier miroir de courant et avec le second miroir de courant entre les deux bornes d'une source de tension d'alimentation V_{DD}. Ceci permet au premier signal de sortie OUT1 de pouvoir varier sur toute la plage de tension d'alimentation ("rail-to-rail" en terminologie anglaise).

La source de courant 3, qui est reliée à la masse, fournit un courant de polarisation I_{P} d'une valeur déterminée par exemple de l'ordre de quelques micro ampères. La source de courant 3 est reliée en série à un premier transistor PMOS monté en diode P5 d'un quatrième miroir de courant. La source du premier transistor PMOS monté en diode P5 est reliée à la borne de potentiel haut V_{DD} d'une source de tension d'alimentation. Le quatrième miroir de courant comprend encore un second transistor PMOS P6, dont la grille est reliée à la grille et au drain du premier transistor PMOS monté en diode P5, et la source est reliée à la borne de potentiel haut V_{DD}. Le courant I_{P} traversant le premier transistor PMOS monté en diode P5 peut ainsi être miroité dans le second transistor PMOS P6 afin de fournir le courant constant I₀ de valeur déterminée aux sources des transistors PMOS de la paire différentielle. Grâce au quatrième miroir de courant avec le second transistor PMOS P6, qui fournit le courant constant I₀, cela permet d'avoir un bon rapport de réjection du bruit d'alimentation (Power Supply Rejection Ratio en terminologie anglaise). Ce second transistor PMOS P6 permet ainsi d'avoir moins de couplage avec la ligne de tension d'alimentation, ce qui conduit à réduire le bruit de l'alimentation électrique.

Pour très peu dégrader le bruit de phase du circuit amplificateur, ce qui est recherché par la présente invention, ledit circuit amplificateur comprend encore deux transistors complémentaires NMOS N6 et N7. Un premier transistor complémentaire NMOS N6 est monté en parallèle avec le premier transistor NMOS monté en diode N2 du premier miroir de courant. Ce premier transistor complémentaire NMOS N6 a donc sa source reliée à la masse et son drain relié à la grille et au drain du premier transistor NMOS N2, ainsi qu'au drain du premier transistor PMOS P3 de la paire différentielle. La grille du premier transistor complémentaire NMOS N6 est reliée à la grille du premier transistor PMOS P3 de la paire, qui constitue une entrée non inverseuse X_{OUT} du circuit amplificateur 1. Ainsi le montage de ce premier transistor complémentaire NMOS N6 avec le premier transistor PMOS P3 de la paire différentielle constitue un montage inverseur.

Un second transistor complémentaire NMOS N7 est monté en parallèle avec le premier transistor NMOS monté en diode N3 du second miroir de courant. Ce second transistor complémentaire NMOS N7 a donc sa source reliée à la masse et son drain relié à la grille et au drain du premier transistor NMOS N3, ainsi qu'au drain du second transistor PMOS P4 de la paire différentielle. La grille du second transistor complémentaire NMOS N7 est reliée à la grille du second transistor PMOS P4 de la paire, qui constitue une entrée inverseuse X_{IN} du circuit amplificateur 1. Ainsi le montage de ce second transistor complémentaire NMOS N7 avec le second transistor PMOS P4 de la paire différentielle constitue un autre montage inverseur.

Grâce aux transistors NMOS complémentaires N6 et N7, ce dispositif permet d'éviter de dégrader fortement le bruit de phase du circuit amplificateur, ou toute gigue importante. Une conversion de signaux oscillants en opposition de phase, qui sont fournis aux entrées X_{IN} et X_{OUT} du circuit amplificateur, peut ainsi être effectuée pour obtenir au moins un signal de sortie à impulsions OUT1 susceptible de s'étendre sur toute la plage de la tension d'alimentation du circuit amplificateur. Un bon rapport cyclique peut aussi être obtenu grâce à la symétrie des entrées de la paire d'inverseurs. Lors de la transition de conduction des transistors PMOS P3 et P4 de la paire différentielle, la tension des grilles des premier ou second miroirs de courant est diminuée de manière active et plus rapidement. Ainsi, le courant dans chaque miroir de courant, qui doit passer dans un état non conducteur, est ainsi diminué rapidement, ce qui permet d'éviter de générer un bruit de phase important. Ces transistors NMOS complémentaires N6 et N7 assurent également un gain supplémentaire important du circuit amplificateur 1.

Le circuit amplificateur 1 peut être alimenté par une source de tension continue d'alimentation non représentée, qui peut être une pile ou batterie. La valeur du potentiel haut V_{DD} de cette source de tension d'alimentation peut être choisie entre 1.5 et 2 V par exemple.

Pour la réalisation des transistors MOS du circuit amplificateur 1 dans un substrat en Silicium du type P, il peut être prévu par exemple que les transistors PMOS P3 et P4 de la paire différentielle aient leur caisson relié à la borne de source. Ceci permet d'augmenter encore le gain du circuit amplificateur par rapport au cas où le caisson est relié directement à la borne du potentiel haut de la tension d'alimentation V_{DD}. Par contre, le caisson des transistors NMOS est relié directement à la masse.

Pour mieux représenter l'avantage du circuit amplificateur 1 avec les transistors NMOS complémentaires N6 et N7, on peut se référer au tableau ci-dessous. Dans ce tableau, il est comparé le bruit de phase en dBc par Hertz (rapport entre la puissance du bruit dans une largeur de bande de 1 Hz et la puissance du signal porteur exprimé en décibels) pour un circuit amplificateur de l'art antérieur comme représenté à la figure 1, et un circuit amplificateur selon l'invention représenté à la figure 2. La fréquence des signaux oscillants provenant d'un oscillateur à quartz est supérieure à 10 MHz, de préférence égale à 16 MHz, et le bruit de phase est comparé à différentes fréquences en décalage par rapport à la fréquence centrale des signaux oscillants dans une largeur de bande de 1 Hz à chaque fréquence de décalage. On peut ainsi remarquer que le bruit de phase du circuit amplificateur de la présente invention est généralement plus de 10 dB en dessous du bruit du circuit amplificateur de l'art antérieur. Ceci procure un très net avantage du circuit amplificateur 1 de la présente invention pour une intégration dans un instrument électronique afin de fournir un signal de sortie d'horloge pour le cadencement d'opérations dudit instrument.

| Fréquence de décalage par rapport à 16MHz | Bruit de phase | |
|---|---|---|
| | Amplificateur de l'art antérieur | Amplificateur de la présente invention |
| 100 Hz | -100 dBc/Hz | -104 dBc/Hz |
| 1 kHz | -108 dBc/Hz | -119 dBc/Hz |
| 10 kHz | -110 dBc/Hz | -134 dBc/Hz |
| 100 kHz | -115 dBc/Hz | -139 dBc/Hz |

En plus des transistors NMOS complémentaires N6 et N7, le circuit amplificateur de la présente invention, comprend un inverseur en sortie du circuit pour fournir un signal de sortie inversé OUT. Cet inverseur est composé d'un transistor NMOS N5 connecté en série avec un transistor PMOS P7 entre les deux bornes de la tension d'alimentation V_{DD}. Les grilles des deux transistors MOS de l'inverseur sont reliées aux drains des seconds transistors NMOS N1 et PMOS P1 des premier et troisième miroirs de courant, et les drains des deux transistors MOS de l'inverseur fournissent le signal de sortie inversé OUT. Cet inverseur permet de convertir le noeud de connexion OUT1 des drains des seconds transistors MOS des premier et troisième miroirs de courant, qui est à haute impédance, en un signal de sortie en basse impédance.

Chaque transistor MOS de chaque miroir de courant peut être de taille identique. Cependant il peut aussi être envisagé dans certains miroirs de courant de réaliser un premier transistor MOS de taille différente du second transistor MOS de manière à miroiter un courant qui est fonction de la taille des transistors MOS du miroir de courant. Généralement les transistors PMOS de la paire différentielle sont de relativement grande dimension comparativement aux autres transistors MOS du circuit amplificateur 1. Cependant il est également recherché de réaliser un circuit amplificateur à faible consommation, qui permet néanmoins de fonctionner à des fréquences supérieures à 10 MHz.

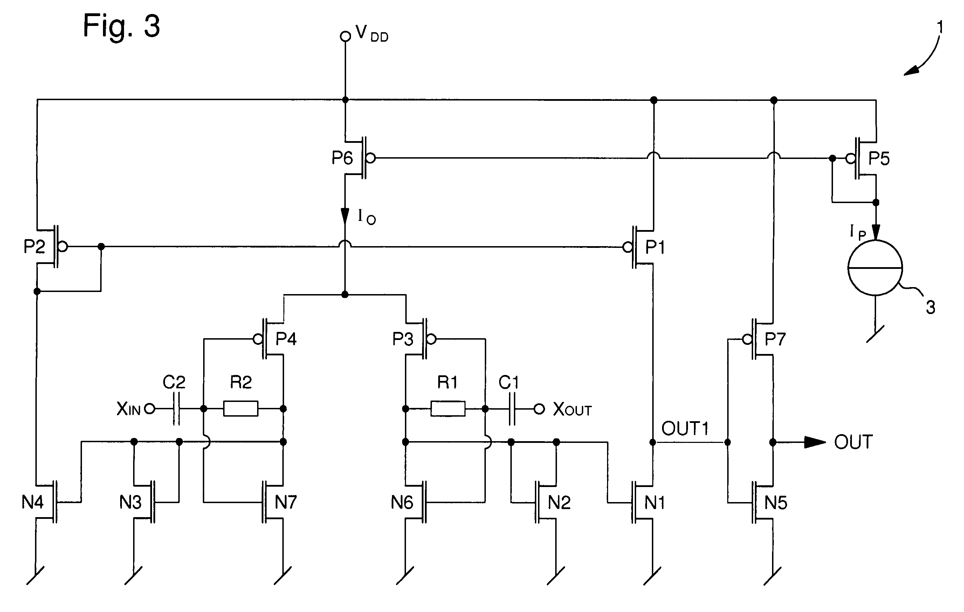

A la figure 3, il est représenté une seconde forme d'exécution d'un circuit amplificateur à faible bruit 1. Comme cette seconde forme d'exécution du circuit amplificateur est très similaire à la première forme d'exécution, il ne sera pas décrit par simplification tous les mêmes éléments, qui portent des signes de référence identiques à ceux représentés à la figure 2.

La seule différence de cette seconde forme d'exécution du circuit amplificateur 1 réside dans l'ajout de condensateurs C1 et C2 et de résistances R1 et R2 à l'entrée du circuit amplificateur. Il est nécessaire que le niveau de la tension DC à l'entrée du circuit amplificateur ne soit pas trop élevé pour assurer que les transistors NMOS complémentaires N6 et N7 fonctionnent si possible en faible inversion pour obtenir le maximum de gain. En général si les signaux d'entrée du circuit amplificateur sont des signaux oscillants provenant d'un oscillateur à quartz du type Pierce, le niveau DC est proche d'une tension de seuil NMOS et les transistors complémentaires N6 et N7 travaillent en faible inversion. De ce fait, la première forme d'exécution de la figure 2 suffit. Toutefois dans d'autres applications, il se peut qu'il doit être tenu compte d'un niveau de tension DC important, ce qui nécessite l'ajout des condensateurs C1 et C2 et des résistances R1 et R2.

Une première résistance R1 est donc disposée entre les grilles et les drains du premier transistor PMOS P3 de la paire différentielle et du premier transistor NMOS complémentaire N6. Un premier condensateur C1 est disposé à l'entrée non inverseuse avec une première électrode reliée aux grilles du premier transistor PMOS P3 et du premier transistor NMOS complémentaire N6, et une seconde électrode X_{OUT} pour recevoir un premier signal oscillant à l'entrée non inverseuse. Une seconde résistance R2 est disposée entre les grilles et les drains du second transistor PMOS P4 de la paire différentielle et du second transistor NMOS complémentaire N7. Un second condensateur C2 est disposé à l'entrée inverseuse avec une première électrode reliée aux grilles du second transistor PMOS P4 et du second transistor NMOS complémentaire N7, et une seconde électrode X_{IN} pour recevoir un second signal oscillant à l'entrée inverseuse, qui est en opposition de phase du premier signal oscillant. La valeur résistive de chaque résistance R1 et R2 doit généralement être d'une valeur supérieure à l'impédance d'entrée des transistors PMOS P3 et P4. Cette valeur résistive peut être choisie de l'ordre de 470 kOhms ou 1 MOhm. La valeur capacitive de chaque condensateur C1 et C2 doit en principe avoir une valeur de basse impédance par rapport à l'impédance d'entrée de la paire différentielle. Dans le cas où la valeur capacitive au niveau de la grille de chaque transistor PMOS P3 et P4 est de l'ordre de 200 fF, la valeur capacitive des condensateurs C1 et C2 peut être de l'ordre de 2 pF. Ceci permet de ne pas trop diminuer la tension des signaux d'entrée sur les grilles des transistors PMOS de la paire différentielle. Ces valeurs résistive et capacitive sont déterminées en fonction également de la fréquence des signaux oscillants, qui peut être de l'ordre de 16 MHz.

Le circuit amplificateur décrit ci-devant peut être avantageusement réalisé sous forme intégrée dans un substrat de Silicium normalement dopé P dans une technologie CMOS à 0.25 µm, à 0.18 µm ou autre. Ceci permet d'obtenir un circuit amplificateur à faible bruit et faible consommation.

Il est à noter que les formes d'exécution présentées aux figures 2 et 3 peuvent être réalisées également au moyen de transistors bipolaires ou d'une combinaison de transistors bipolaires et MOS (BiCMOS). Dans le cas d'une réalisation avec des transistors bipolaires, il peut être prévu de monter en série avec les transistors de l'inverseur de sortie, une source de courant dans le cas où la tension d'alimentation est trop élevée. Avec un circuit amplificateur réalisé avec des transistors bipolaires, le bruit de phase généré par ledit circuit amplificateur est généralement inférieur à celui du circuit amplificateur réalisé avec des transistors MOS. Cependant avec des transistors bipolaires, le circuit amplificateur peut être plus fort consommateur en énergie électrique.

A partir de la description qui vient d'être faite, plusieurs variantes du circuit amplificateur à faible bruit de phase peuvent être conçues par l'homme du métier sans sortir du cadre de l'invention définie par les revendications. Le circuit amplificateur peut aussi être réalisé avec une paire différentielle de transistors NMOS, des premier et second miroirs de courant avec des transistors PMOS, des troisièmes et quatrième miroirs de courant avec des transistors NMOS, et des transistors PMOS complémentaires.

## Revendications

1. Circuit amplificateur (1) comprenant une paire différentielle de transistors en entrée (P3, P4) d'un premier type de conductivité, la source ou l'émetteur de chaque transistor de la paire étant relié pour recevoir un courant généré via une source de courant (I₀, 3), la grille ou la base d'un premier transistor (P3) de la paire définissant une entrée non inverseuse (X_{OUT}) et la grille ou la base du second transistor (P4) de la paire définissant une entrée inverseuse (X_{IN}), un drain ou un collecteur du premier transistor (P3) de la paire différentielle étant relié à un transistor monté en diode (N2) d'un second type de conductivité d'un premier miroir de courant (N1, N2), et un drain ou un collecteur du second transistor (P4) de la paire différentielle étant relié à un transistor monté en diode (N3) d'un second type de conductivité d'un second miroir de courant (N3, N4), un transistor monté en diode (P2) d'un premier type de conductivité d'un troisième miroir de courant étant relié au drain ou collecteur d'un second transistor (N4) d'un second type de conductivité du second miroir de courant, alors qu'un drain ou un collecteur d'un second transistor (P1) d'un premier type de conductivité du troisième miroir de courant étant relié au drain ou collecteur d'un second transistor (N1) d'un second type de conductivité du premier miroir de courant pour définir une sortie (OUT1) du circuit amplificateur, le troisième miroir de courant étant monté en série avec le premier miroir de courant et avec le second miroir de courant entre deux bornes d'une source de tension d'alimentation (V_{DD}) pour permettre au signal de sortie (OUT1) une excursion sur toute la plage de tension d'alimentation,
**caractérisé en ce qu'**il comprend un premier transistor complémentaire (N6) d'un second type de conductivité monté en parallèle avec le transistor monté en diode (N2) du premier miroir de courant et monté sous forme d'inverseur avec le premier transistor (P3) de la paire différentielle, la grille ou la base du premier transistor complémentaire étant reliée à la grille ou la base du premier transistor de la paire différentielle, et **en ce qu'**il comprend un second transistor complémentaire (N7) d'un second type de conductivité monté en parallèle avec le transistor monté en diode (N3) du second miroir de courant et monté sous forme d'inverseur avec le second transistor (P4) de la paire différentielle, la grille ou la base du second transistor complémentaire étant reliée à la grille ou la base du second transistor de la paire différentielle.

2. Circuit amplificateur (1) selon la revendication 1, **caractérisé en ce qu'**il comprend un quatrième miroir de courant, qui comprend un transistor monté en diode (P5) d'un premier type de conductivité relié à la source de courant (3) en série entre les deux bornes de la tension d'alimentation (V_{DD}), et un second transistor (P6) d'un premier type de conductivité relié au transistor monté en diode pour miroiter dans une certaine proportion le courant de la source de courant et fournir le courant miroité aux sources ou émetteurs des transistors (P3, P4) de la paire différentielle.

3. Circuit amplificateur (1) selon l'une des revendications 1 et 2, **caractérisé en ce que** les premier et second transistors de la paire différentielle sont des transistors PMOS, **en ce que** les transistors des premier et second miroirs de courant sont des transistors NMOS, dont la source est reliée à une borne de potentiel bas de la source de tension d'alimentation (V_{DD}), **en ce que** les transistors des troisième et quatrième miroirs de courant sont des transistors PMOS, dont la source est reliée à une borne de potentiel haut de la source de tension d'alimentation (V_{DD}), et **en ce que** les premier et second transistors complémentaires sont des transistors NMOS.

4. Circuit amplificateur (1) selon l'une des revendications précédentes, **caractérisé en ce qu'**il comprend un inverseur (N5, P7), qui est composé d'un transistor NMOS (N5) connecté en série avec un transistor PMOS (P7) entre les deux bornes de la tension d'alimentation (V_{DD}), les grilles des deux transistors MOS de l'inverseur étant reliées aux drains ou collecteurs des seconds transistors (N1, P1) des premier et troisième miroirs de courant, et les drains des deux transistors de l'inverseur fournissant un signal de sortie inversé (OUT).

5. Circuit amplificateur (1) selon l'une des revendications précédentes, **caractérisé en ce qu'**il comprend une première résistance (R1) disposée entre les grilles et les drains du premier transistor MOS (P3) de la paire différentielle et du premier transistor complémentaire (N6) et une seconde résistance (R2) disposée entre les grilles et les drains du second transistor MOS (P4) de la paire différentielle et du second transistor complémentaire (N7), pour assurer un fonctionnement des transistors complémentaires en faible inversion.

6. Circuit amplificateur (1) selon la revendication 5, **caractérisé en ce qu'**il comprend un premier condensateur (C1), dont une première électrode est reliée à la grille du premier transistor MOS (P3) de la paire différentielle et une seconde électrode (X_{OUT}) est prévue pour recevoir un premier signal oscillant, et un second condensateur (C2), dont une première électrode est reliée à la grille du second transistor MOS (P4) de la paire différentielle et une seconde électrode (X_{IN}) est prévue pour recevoir un second signal oscillant en opposition de phase du premier signal oscillant.

7. Circuit amplificateur (1) selon l'une des revendications précédentes, **caractérisé en ce que** les transistors MOS du circuit sont configurés de telle manière à permettre une conversion de deux signaux oscillants de forme sinusoïdale en opposition de phase de fréquence supérieure à 10 MHz, fournis respectivement à l'entrée inverseuse (X_{IN}) et à l'entrée non inverseuse (X_{OUT}) du circuit, en au moins un signal de sortie à impulsions (OUT1, OUT) sur toute la plage de tension d'alimentation.

8. Circuit amplificateur (1) selon l'une des revendications précédentes, **caractérisé en ce que** les transistors MOS du circuit sont configurés pour réduire d'au moins 10 dB le bruit de phase par rapport au bruit généré par une structure sans transistors MOS complémentaires (N6, N7) pour une fréquence de signaux oscillants en entrée du circuit de l'ordre de 16 MHz.

9. Circuit amplificateur (1) selon l'une des revendications précédentes, **caractérisé en ce que** les transistors MOS (P3, P4) de la paire différentielle sont des transistors PMOS, dont le caisson est relié électriquement à la source, pour augmenter le gain du circuit amplificateur.

## Claims

1. Amplifier circuit (1) inducting a differential pair of transistors (P3, P4) at input, with a first type of conductivity, wherein source or emitter of each transistor of the pair is connected to receive a current generated by a current source (I₀, 3), a gate or base of a first transistor (P3) of the pair defines a non-inverting input (X_{OUT}) and a gate or base of the second transistor (P4) of the pair defines an inverting input (X_{IN}), a drain or collector of the first transistor (P3) of the differential pair is connected to a diode connected transistor (N2), with second type of conductivity, of a first current mirror, (N1, N2), and a drain or collector of the second transistor (P4) of the differential pair is connected to diode connected transistor (N3), with second type of conductivity, of a second current mirror (N3, N4), a diode connected transistor (P2), with a first type of conductivity, of third current mirror is connected to a drain or collector of second transistor (N4), with a second type of conductivity, of the second current mirror, while a drain or collector of second transistor (P1), with a first type of conductivity, of the third current mirror is connected to a drain or collector of a second transistor (N1), with a second type of conductivity, of the first current mirror to define an output (OUT1) of the amplifier circuit, the third current mirror is connected in series with the first current mirror and with the second current mirror between two terminals of supply voltage source (V_{DD}) to allow the output signal (OUT1) to operate rail to rail,
**characterized in that** it includes a first complementary transistor (N6), with a second type of conductivity, connected in parallel with the diode connected transistor (N2) of the first current mirror and connected in the form of a reverser with the first transistor (P3) of the differential pair, wherein a gate or base of the first complementary transistor is connected to the gate or base of the first transistor of the differential pair, and **in that** it includes second complimentary transistor (N7), with a second type of conductivity, connected in parallel with the diode connected transistor (N3) of the second current mirror, and connected in the form of reverser with the second transistor (P4) of the differential pair, wherein a gate or base of the second complementary transistor is connected to the gate or base of the second transistor of the differential pair.

2. Amplifier circuit (1) according to claim 1, **characterized in that** it includes a fourth current mirror, which includes a diode connected transistor (P5), with a first type of conductivity, connected to the current source (3) in series between the two terminals of the supply voltage (V_{DD}), and a second transistor (P6), with a first type of conductivity, connected to the diode connected transistor to mirror, in a certain proportion, the current of the current source and to supply the mirrored current to the sources or emitters of the transistors (P3, P4) of the differential pair.

3. Amplifier circuit (1) according to any of claims 1 and 2, **characterized in that** the first and second transistors of the differential pair are PMOS transistors, **in that** the transistors of the first and second current mirrors are NMOS transistors, whose source is connected to a low potential terminal of the supply voltage source (V_{DD}), **in that** the transistors of the third and fourth current mirrors are PMOS transistors, whose source is connected to a high potential terminal of the supply voltage source (V_{DD}), and **in that** the first and second complementary transistors are NMOS transistors.

4. Amplifier circuit (1) according to any of the preceding claims, **characterized in that** it includes a reverser (N5, P7), which is formed of an NMOS transistor (N5) connected in series with a PMOS transistor (P7) between the two terminals of the supply voltage (V_{DD}), wherein gates of the two MOPS transistors of the reverser are connected to the drains or collectors of the second transistors (N1, P1) of the first and third current mirrors, and drains of the two transistors of the reverser supply an inverted output signal (OUT).

5. Amplifier circuit (1) according to any of the preceding claims, **characterized in that** it includes a first resistor (R1) arranged between the gates and drains of the first MOS transistor (P3) or the differential pair sand the first complementary transistor (N6) and a second resistor (R2) arranged between the gates and drains of the second MOS transistor (P4) of the differential pair and the second complementary transistor (N7), to ensure that the complementary transistors operate in low inversion.

6. Amplifier circuit (1) according to claim 5, **characterized in that** it includes a first capacitor (C1), whose first electrode is connected to the gate of the first MOPS transistor (P3) of the differential pair and a second electrode (X_{OUT}) is provided for receiving a first oscillating signal, and a second capacitor (C2), whose first electrode is connected to the gate of the second MOS transistors (P4) of the differential pair, and a seconds electrode (X_{IN}) is provided for receiving a second oscillating signal in phase opposition to the first oscillating signal.

7. Amplifier circuit (1) according to any of the preceding claims, **characterized in that** the MOS transistors of the circuit are configured to allow conversion of two oscillating, sinusoidal signals in phase opposition at a higher frequency than 10 MHz, respectively supplied to the inverting input (X_{IN}) and to the non-inverting input (X_{OUT}) of the circuit, into at least one rail to rail output pulse signal (OUT1, OUT).

8. Amplifier circuit (1) according to any of the preceding claims, **characterized in that** the MOS transistors of the circuit are configured to reduce phase noise by at least 10 dB compared to the noise generated by a structure without any complementary MOS transistors (N6, N7) for an oscillating signal frequency at the circuit input of around 16 MHz.

9. Amplifier circuit (1) according to any of the preceding claims, **characterized in that** the MOPS transistors (P3, P4) of the differential pair are PMOS transistors, whose well is electrically connected to the source, to increase the amplifier circuit gain.

## Patentansprüche

1. Verstärkerschaltung (1), mit eiern differentiellen Eingangstransistorpaar (P3, P4) eines ersten Leitfähigkeitstyps, wobei die Source oder der Emitter jedes Transistors des Paars angeschlossen ist, um einen Strom zu empfangen, der durch eine Stromquelle (I₀, 3) erzeugt wird, wobei das Gate oder die Basis eines ersten Transistors (P3) des Paars einen nicht invertierenden Eingang (X_{OUT}) definiert und das Gate oder die Basis des zweiten Transistors (P4) des Paars einen invertierenden Eingang (X_{IN}) definiert, wobei ein Drain oder ein Kollektor des ersten Transistors (P3) des differentiellen Paars mit einem als Diode geschalteten Transistor (N2) eines zweiten Leitfähigkeitstyps eines ersten Stromspiegels (N1, N2) verbunden ist und ein Drain oder ein Kollektor des zweiten Transistors (P4) des differentiellen Paars mit einem als Diode geschalteten Transistor (N3) eines zweiten Leitfähigkeitstyps eines zweiten Stromspiegels (N3, N4) verbunden ist, wobei ein als Diode geschalteter Transistor (P2) eines ersten Leitfähigkeitstyps eines dritten Stromspiegels mit dem Drain oder Kollektor eines zweiten Transistors (N4) eines zweiten Leitfähigkeitstyps des zweiten Stromspiegels verbunden ist, während ein Drain oder ein Kollektor eines zweiten Transistors (P1) eines ersten Leitfähigkeitstyps des dritten Stromspiegels mit dem Drain oder Kollektor eines zweiten Transistors (N1) eines zweiten Leitfähigkeitstyps des ersten Stromspiegels verbunden ist, um einen Ausgang (OUT1) der Verstärkerschaltung zu definieren, wobei der dritte Stromspiegel in Reihe mit dem ersten Stromspiegel und mit dem zweiten Stromspiegel zwischen zwei Abschlüsse einer Versorgungsspannungsquelle (V_{DD}) geschaltet ist, um dem Ausgangssignal (OUT1) einen Ausschlag über den gesamten Versorgungsspannungsbereich zu ermöglichen,
**dadurch gekennzeichnet, dass** sie einen ersten komplementären Transistor (N6) eines zweiten Leitfähigkeitstyps umfasst, der zu dem als Diode geschalteten Transistor (N2) des ersten Stromspiegels parallelgeschaltet ist und mit dem ersten Transistor (P3) des differentiellen Paars als Inverter geschaltet ist, wobei das Gate oder die Basis des ersten komplementären Transistors mit dem Gate oder der Basis des ersten Transistors des differentiellen Paars verbunden ist, und dass sie einen zweiten komplementären Transistor (N7) eines zweiten Leittähigkeitstyps umfasst, der zu dem als Diode geschalteten Transistor (N3) des zweiten Stromspiegels parallelgeschaltet ist und mit dem zweiten Transistor (P4) des differentiellen Paars als Inverter geschaltet ist, wobei das Gate oder die Basis des zweiten komplementären Transistors mit dem Gate oder der Basis des zweiten Transistors des differentiellen Paars verbunden ist.

2. Verstärkerschalturig (1) nach Anspruch 1, **dadurch gekennzeichnet, dass** sie einen vierten Stromspiegel umfasst, der einen als Diode geschalteten Transistor (P5) eines ersten Leitfähigkeitstyps, der in Reihe mit dem Stromspiegel (3) zwischen den Versorgungsspannungsanschlüssen (V_{DD}) verbunden ist, und einen zweiten Transistor (P6) eines ersten Leitfähigkeitstyps, der mit dem als Diode geschalteten Transistor verbunden ist, um den Strom der Stromquelle in einem bestimmten Anteil zu spiegeln und den gespiegelten Strom zu den Sources oder Emittern der Transistoren (P3, P4) des differentiellen Paars zu liefern, enthält.

3. Verstärkerschaltung (1) nach einem der Ansprüche 1 und 2, **dadurch gekennzeichnet, dass** der erste und der zweite Transistor des differentiellen Paars PMOS-Transistoren sind, dass die Transistoren des ersten und des zweiten Stromspiegels NMOS-Transistoren sind, wovon die Source mit einem Anschluss auf niedrigem Potential der Versorgungsspannungsquelle (V_{DD}) verbunden ist, dass die Transistoren des dritten und des vierten Stromspiegels PMOS-Transistoren sind, wovon die Source mit einem Anschluss auf hohem Potential der Versorgungsspannungsquelle (V_{DD}) verbunden ist, und dass der erste und der zweite komplementäre Transistor NMOS-Transistoren sind.

4. Verstärkerschaltung (1) nach einem der vorhergehenden Ansprüche, **dadurch gekennzeichnet, dass** sie einen Inverter (N5, P7) umfasst, der aus einem NMOS-Transistor (N5) gebildet ist, der mit einem PMOS-Transistor (P7) zwischen den zwei Anschlüssen der Versorgungsspannung (V_{DD}) in Reihe geschaltet ist, wobei die Gates der zwei MOS-Transistoren des Inverters mit den Drains oder Kollektoren der zweiten Transistoren (N1, P1) des ersten und des dritten Stromspiegels verbunden sind und wobei die Drains der zwei Invertertransistoren ein invertiertes Ausgangssignal (OUT) liefern.

5. Verstärkerschaltung (1) nach einem der vorhergehenden Ansprüche, **dadurch gekennzeichnet, dass** sie einen ersten Widerstand (R1), der zwischen den Gates und den Drains des ersten MOS-Transistors (P3) des differentiellen Paars und des ersten komplementären Transistors (N6) angeordnet ist, und einen zweiten Widerstand (R2), der zwischen den Gates und den Drains des zweiten MOS-Transistors (P4) des differentiellen Paars und dem zweiten komplementären Transistor (N7) angeordnet ist, umfasst, um einen Betrieb der komplementären Transistoren mit geringer Inversion zu gewährleisten.

6. Verstärkerschaltung (1) nach Anspruch 5, **dadurch gekennzeichnet, dass** sie einen ersten Kondensator (C1), wovon eine erste Elektrode mit dem Gate des ersten MOS-Transistors (P3) des differentiellen Paars verbunden ist und eine zweite Elektrode (X_{OUT}) vorgesehen ist, um ein erstes oszillierendes Signal zu empfangen, und einen zweiten Kondensator (C2), wovon eine erste Elektrode mit dem Gate des zweiten MOS-Transistors (P4) des differentiellen Paars verbunden ist und eine zweite Elektrode (X_{IN}) vorgesehen ist, um ein zweites oszillierendes Signal mit zu dem ersten oszillierenden Signal entgegengesetzter Phase zu empfangen, umfasst.

7. Verstärkerschaltung (1) nach einem der vorhergehenden Ansprüche, **dadurch gekennzeichnet, dass** die MOS-Transistoren der Schaltung in der Weise konfiguriert sind, dass eine Umsetzung der zwei sinusförmig oszillierenden Signale mit entgegengesetzter Phase und einer Frequenz oberhalb von 10 MHz, die an den invertierenden Eingang (X_{IN}) bzw. an den nicht invertierenden Eingang (X_{OUT}) der Schaltung geliefert werden, in wenigstens ein Impulsausgangssignal (OUT1, OUT) auf dem gesamten Versorgungsspannungsbereich ermöglicht wird.

8. Verstärkerschaltung (1) nach einem der vorhergehenden Ansprüche, **dadurch gekennzeichnet, dass** die MOS-Transistoren der Schaltung konfiguriert sind, um das Phasenrauschen in Bezug auf das Rauschen, das durch eine Struktur ohne komplementäre MOS-Transistoren (N6, N7) erzeugt wird, bei einer Frequenz der oszillierenden Signale am Eingang der Schaltung in der Größenordnung von 16 MHz um wenigstens 10 dB zu reduzieren.

9. Verstärkerschaltung (1) nach einem der vorhergehenden Ansprüche, **dadurch gekennzeichnet, dass** die MOS-Transistoren (P3, P4) des differentiellen Paars PMOS-Transistoren sind, deren Wanne mit der Source elektrisch verbunden ist, um die Verstärkung der Verstärkerschaltung zu erhöhen.
